# EUROPEAN PATENT APPLICATION

(11) **EP 4 668 320 A1**
(43) Date of publication of application: **24.12.2025**
(21) Application number: 25172246.8
(22) Date of filing: 24.04.2025
(51) Int. Cl.: H01L 21/48, H01L 23/15, H01L 23/433, H01L 23/498, H01L 23/538, H01L 23/552

(54) **INTEGRATED CIRCUIT PACKAGES INCLUDING SUBSTRATES WITH ENCAPSULATED GLASS CORES**

(30) Priority: 21.06.2024 US 202418749903
(71) Applicant: Intel Corporation, Santa Clara, CA 95054 (US)
(72) Inventor: JIMENEZ, Andrew, Mesa, AZ 85210 (US); KONCHADY, Manohar, Chandler, AZ 85248 (US); RAMANUJA PIETAMBARAM, Srinivas Venkata, Chandler 85249 (US); WANG, Yekan, Chandler, AZ 85286 (US); XIE, Zhixin, Chandler 85249 (US)
(74) Representative: HGF

(57) **Abstract**

Disclosed herein are microelectronic assemblies including strengthened glass layers, as well as related devices and methods. In some embodiments, a microelectronic assembly may include a glass layer including a cavity and having a first surface, an opposing second surface, and side surfaces extending between the first and second surfaces; a material in the cavity and on the first, second, and side surfaces of the glass layer; a first conductive via extending through the glass layer and through the material on the first and second surfaces of the glass layer; a second via extending through the material in the cavity, the second via including a conductive material surrounded by a magnetic material; and a dielectric layer on the material at the first surface of the glass layer, the dielectric layer including conductive pathways electrically coupled to the first conductive via and the second via.

## Description

### TECHNICAL FIELD

The present disclosure relates to techniques, methods, and apparatus directed to substrates having an encapsulated glass core for heterogeneous integrated circuit (IC) packaging architecture.

### BACKGROUND

Electronic circuits when fabricated on a wafer of semiconductor material, such as silicon, are commonly called integrated circuits (ICs). The wafer with such ICs is typically cut into numerous individual dies. The dies may be packaged into an IC package containing one or more dies along with other electronic components such as resistors, capacitors, and inductors. The IC package may be integrated onto an electronic system, such as a consumer electronic system.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a schematic cross-sectional view of an example microelectronic assembly according to some embodiments of the present disclosure.
FIG. 2 is a schematic cross-sectional view of another example microelectronic assembly according to some embodiments of the present disclosure.
FIG. 3 is a schematic cross-sectional view of yet another example microelectronic assembly according to some embodiments of the present disclosure.
FIG. 4 is a schematic cross-sectional view of yet another example microelectronic assembly according to some embodiments of the present disclosure.
FIGS. 5A and 5B are simplified cross-sectional views illustrating example microelectronic assemblies during manufacturing and prior to singulation according to some embodiments of the present disclosure.
FIGS. 6A-6O are simplified cross-sectional views illustrating various manufacturing steps of an example microelectronic assembly according to some embodiments of the present disclosure.
FIGS. 7A-7J are simplified cross-sectional views illustrating various manufacturing steps of another example microelectronic assembly according to some embodiments of the present disclosure.
FIGS. 8A-8E are simplified cross-sectional views illustrating various manufacturing steps of yet another example microelectronic assembly according to some embodiments of the present disclosure.
FIG. 9 is a cross-sectional view of a device package that may include one or more microelectronic assemblies in accordance with any of the embodiments disclosed herein.
FIG. 10 is a cross-sectional side view of a device assembly that may include one or more microelectronic assemblies in accordance with any of the embodiments disclosed herein.
FIG. 11 is a block diagram of an example computing device that may include one or more microelectronic assemblies in accordance with any of the embodiments disclosed herein.

### DETAILED DESCRIPTION

For purposes of illustrating IC packages described herein, it is important to understand phenomena that may come into play during assembly and packaging of ICs. The following foundational information may be viewed as a basis from which the present disclosure may be properly explained. Such information is offered for purposes of explanation only and, accordingly, should not be construed in a way that limits the broad scope of the present disclosure and its potential applications.

Die partitioning, in which multiple smaller dies are coupled together by high-density interconnects, may achieve smaller form factors and higher yields than utilizing a single, monolithic die. However, coupling dies together at the fine pitch needed to achieve desired interconnect density has been limited by conventional approaches. One approach to achieving a finer pitch includes incorporating a thin glass core into a package substrate.

The structures and assemblies disclosed herein may include a glass core, also referred to herein as a "glass layer," encapsulated in a material. A glass core as compared to a conventional epoxy core offers several advantages including higher through-glass via (TGV) density, lower signal losses, and lower total thickness variation (TTV), among others. However, the manufacture of glass core substrates, especially using existing high volume manufacturing equipment, may be challenging due to the brittleness of glass, which may form cracks that may propagate and cause malfunctions in electrical circuitry. A glass core having a via opening and a cavity opening may be reinforced during manufacturing by placing the glass core in a frame on a carrier then encapsulating the glass core with a dielectric material (e.g., forming a protective material that surrounds the glass core on a top surface, on a bottom surface, and on side surfaces). A glass core may be further protected by including a reinforcing material that bridges a gap between the edge of the glass core and the frame. A glass core may not include a seed layer between the glass core and a conductive material of a through-glass via (TGV), but may include a space between the glass core and the conductive material of the TGV, which allows for expansion and retraction of the conductive material without increasing stress on the glass core. In another example, the glass core may include a liner layer between the glass core and the conductive material of the TGV, and may further include with a space between the liner layer and the conductive material of the TGV to allow for expansion and retraction of the conductive material without increasing stress on the glass core. An IC package, with a reinforced glass core, may be less susceptible to damage resulting from manufacturing operations, including singulating (e.g., by sawing) into individual units and metallization region formation. A metallization region may include a dielectric material with conductive pathways therein formed on a surface of the glass core (e.g., on a top surface, on a bottom surface, or on top and bottom surfaces). A dielectric material including conductive pathways also may be referred to herein as a redistribution layer (RDL). TGVs and other conductive pathways through the glass core may provide for front-to-back connections between two different metallization regions. The RDLs may provide routing for design flexibility, and the encapsulated glass core may provide dimensional stability, allowing the structures and assemblies disclosed herein to exhibit little to no warpage.

Accordingly, disclosed herein are microelectronic assemblies including a glass layer having a first surface, an opposing second surface, and side surfaces extending between the first and second surfaces, the glass layer including a cavity; a material in the cavity and on the first, second, and side surfaces of the glass layer, wherein the material includes an organic dielectric; a first via extending through the glass layer and through the material on the first and second surfaces of the glass layer, the first via including a conductive material; a second via extending through the material in the cavity, the second via including a conductive material surrounded by a magnetic material; and a dielectric layer on the material at the first surface of the glass layer, the dielectric layer including a first conductive pathway electrically coupled to the first via and a second conductive pathway electrically coupled to the second via.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are stated in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may comprise substantially monocrystalline semiconductors, such as silicon or germanium, as a base material on which integrated circuits are fabricated with traditional semiconductor processing methods. The semiconductor base material may include, for example, N-type or P-type materials. Dies may include, for example, a crystalline base material formed using a bulk silicon (or other bulk semiconductor material) or a semiconductor-on-insulator (SOI, e.g., a silicon-on-insulator) structure. In some other embodiments, the base material of one or more of the IC dies may comprise alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may comprise compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may comprise an intrinsic IV or III-V semiconductor material or alloy, not intentionally doped with any electrically active impurity; in alternate embodiments, nominal impurity dopant levels may be present. In still other embodiments, dies may comprise a non-crystalline material, such as polymers; for example, the base material may comprise silica-filled epoxy. In other embodiments, the base material may comprise high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of input/output (I/O) functions, arithmetic operations, pipelining of data, etc.).

In another example, the terms "package" and "IC package" are synonymous, as are the terms "die" and "IC die." Note that the terms "chip," "chiplet," "die," and "IC die" are used interchangeably herein.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., metal oxide semiconductor (MOS) FETs (MOSFETs). In general, a FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PCI. In such cases, the term "interconnect" may refer to optical waveguides (e.g., structures that guide and confine light waves), including optical fiber, optical splitters, optical combiners, optical couplers, and optical vias.

The term "conductive trace" may be used to describe an electrically conductive element isolated by an insulating material. Within IC dies, such insulating material comprises interlayer low-k dielectric that is provided within the IC die. Within package substrates, and printed circuit boards (PCBs) such insulating material comprises organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

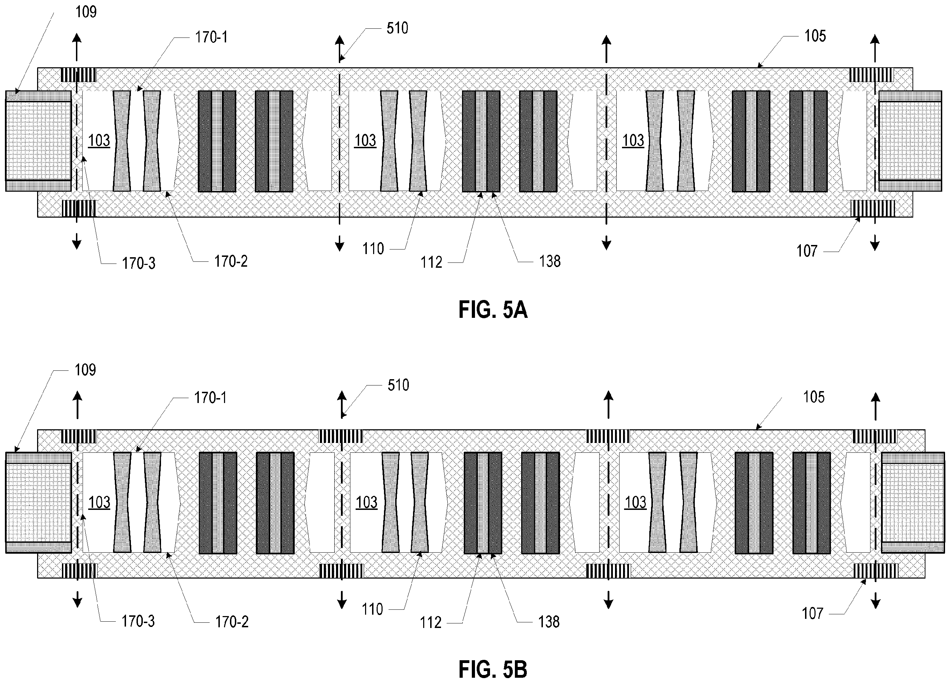

For convenience, if a collection of drawings designated with different letters are present (e.g., FIGS. 5A and 5B), such a collection may be referred to herein without the letters (e.g., as "FIG. 5"). Similarly, if a collection of reference numerals designated with different numbers are present (e.g., 148-1, 148-2), such a collection may be referred to herein without the numbers (e.g., as "148").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

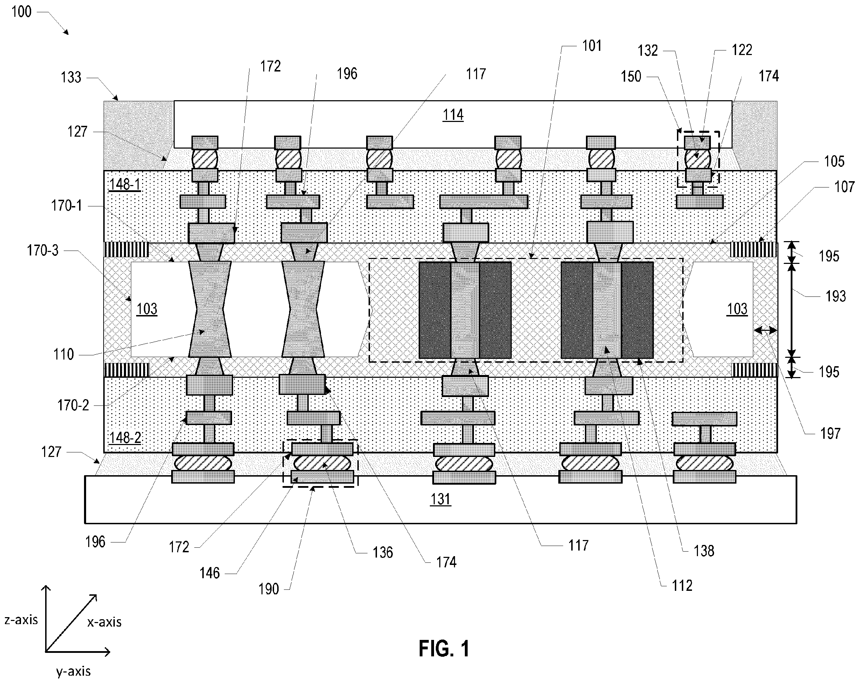

FIG. 1 is a schematic cross-sectional view of an example microelectronic assembly 100 according to some embodiments of the present disclosure. Microelectronic assembly 100 may include a glass layer 103 surrounded by an encapsulating material 105. The glass layer 103 may include one or more TGVs 110 through a glass material. The glass layer 103 may further include a cavity 101 (e.g., as indicated by the dotted lines) and the cavity 101 may include one or more through-dielectric vias (TDVs) 112 extending through the encapsulating material in the cavity 101. TGV 110 and TDV 112 may include a conductive material. In some embodiments, TDV 112 may be surrounded by a magnetic material 138 (e.g., the magnetic material 138 may be between the conductive material of the TDV 112 and the encapsulating material 105 in the cavity 101). In such embodiments, TDV 112 may be referred to herein as a "magnetic via" for a coaxial magnetic inductor, for example. The encapsulating material 105 may protect the glass layer 103 and reduce damage resulting from compression and tensile stress.

A glass layer 103 may have a first surface 170-1 (e.g., a top surface), an opposing second surface 170-2 (e.g., a bottom surface), and side surfaces 170-3 extending between the first and second surfaces. An encapsulating material 105 may surround the glass layer 103 (e.g., the encapsulating material 105 may be on the first, second, and sides surfaces 170-1, 170-2, 170-3 of the glass layer 103). An encapsulating material 105 may include a dielectric material, such as an organic dielectric, a mold material, or an epoxy material, such as an epoxy material with silica fillers or an epoxy-based organic material. In some embodiments, an encapsulating material 105 may have a thickness 195 (e.g., a z-height from a first surface 170-1 or a second surface 170-2 of the glass layer 103) between 5 microns and 100 microns. A width 197 of the encapsulating material 105 may depend on a singulation process. In some embodiments, an encapsulating material 105 may have a width 197 (e.g., y-dimension) between 10 microns and 500 microns.

A glass layer 103 may include any suitable type of glass known in the art, including but not limited to any type of bulk amorphous or polycrystalline transparent, opaque, or semi-transparent glass, such as borosilicate glass, soda lime glass, quartz, a fused-silica glass, an alkali glass, a ceramic glass, or other solid volume of glass material. As used herein, a glass layer 103 does not include glass fiber reinforced polymers. In some embodiments, the glass layer 103 may include a photoimageable glass, a photoglass, or other borosilicate-based glasses with oxide additions. In some embodiments, a thickness 193 of a glass layer 103 may be between 50 microns and 1500 microns (i.e., between 100 microns and 1 millimeter).

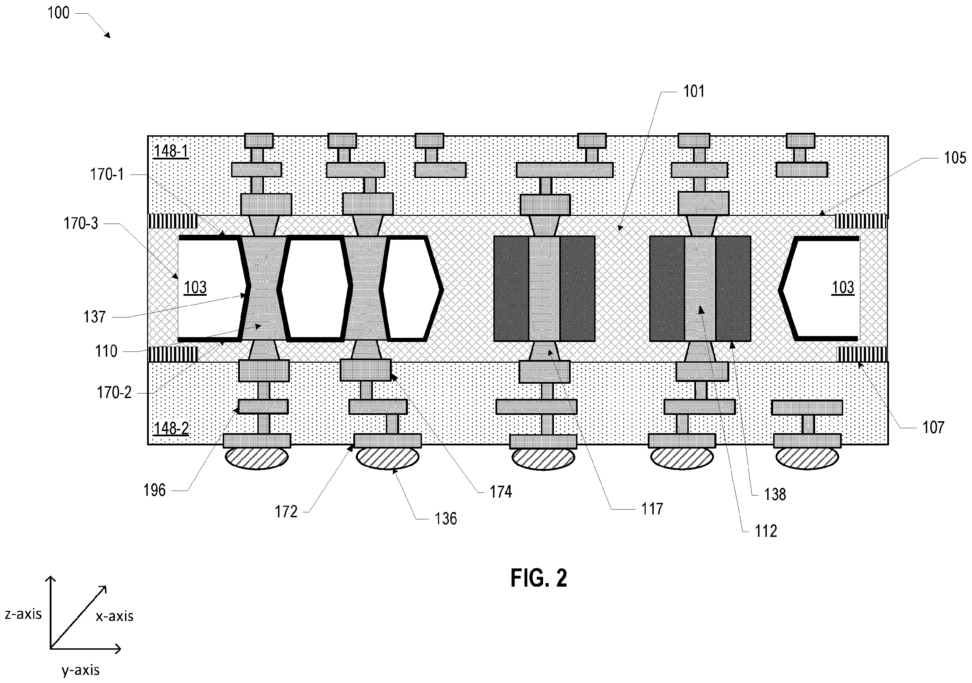

As described above, the microelectronic assembly 100 may further include one or more through-vias (e.g., TGV 110 and TDV 112). TGV 110 and TDV 112 may electrically couple with conductive vias 117 through the encapsulating material 105 on the first and second surfaces 170-1, 170-2 of the glass layer 103. The one or more through-vias may enable power, ground and signal connectivity to components located on either side of the glass layer 103, for example, between die 114 and a circuit board 131. TGVs 110, TDVs 112, and conductive vias 117 may have any suitable size and shape. TGVs 110 are shown as having tapered edges towards a center; however, in various embodiments, TGVs 110 may have straight, parallel edges and/or have other irregularities depending on the processing conditions for generating TGVs 110. TDVs 112 are shown having straight, parallel edges; however, in various embodiments, TGVs 110 may have tapered edges and/or have other irregularities depending on the processing conditions for generating TDVs 112. TGVs 110, TDVs 112, and conductive vias 117 may be formed using any suitable process, including, for example, laser drilling via openings through the glass layer 103 or the encapsulating material 105, and depositing a conductive material in the openings. In some embodiments, TGVs 110 may be formed using a laser ablation and chemical etching process. TGVs 110, TDVs 112, and conductive vias 117 may be formed of any suitable conductive material, such as copper, silver, nickel, gold, aluminum, or other metals or alloys, for example. TGV 110 may not include a seed layer between a material of the glass layer 103 and the conductive material of the TGV 110, and, instead of adhering to the material of the glass layer 103, the conductive material of the TGV 110 snugly against the material of the glass layer 103. In some embodiments, a space or gap of between 50 nanometers and 200 nanometers may exist between the material of the glass layer 103 and the conductive material of the TGV 110, such that the conductive material of the TGV 110 may expand and contract due to thermal cycling without stressing or cracking the glass layer 103. In some embodiments, the microelectronic assembly 100 may include a liner material 137, as described below with reference to FIG. 2, to further reduce stress from the expansion and contraction of the conductive material of the TGV 110. In some embodiments, a diameter of the TGVs 110 and TDVs 112 may be between 25 microns and 200 microns (e.g., between 50 microns and 100 microns). In some embodiments, a pitch of the TGVs 110 and TDVs 112 may be between 1.5 times the diameter (e.g., between 37.5 microns and 300 microns).

A magnetic material 138 may have any suitable dimensions, for example, a width (e.g., y-dimension) of the magnetic material 138 between 0.5 micron and 10 microns. A magnetic material 138 may be formed of any suitable magnetic material, such as a ferromagnetic material. In some embodiments, a magnetic material 138 may include a high magnetic permeability film, paste, or liquid suitable for forming the magnetic material. In some embodiments, a magnetic material 138 may be formed of a dielectric with magnetic particles or flakes. For example, a magnetic material 138 may include an epoxy resin with magnetic particles or flakes, such as iron, nickel, cobalt, and their alloys, where the magnetic particles have a diameter between 5 nanometers and 500 nanometers, and are distributed throughout the dielectric material. In some embodiments, suitable magnetic materials may include iron, nickel, cobalt, or nickel-iron alloys (e.g., Mu metals and/or permalloys). In some embodiments, suitable magnetic materials may include one or more of FeO, Fe₂O₃, CdZnTe, CrO₂, NiO, NiOFe₂O₃, CuO, CuOFe₂O₃, MgO, MgOFe₂O₃, MnAs, MnBi, MnSb, MnO, MnOFe₂O₃, Y₃Fe₅O₁₂ (YIG), Nd, Nd₂O₃, Pr, Sm, Sm₂O₃, Tb, Tb₂O₃, Tm, Tm₂O₃, or epoxy material with particles of a magnetic alloy. In some embodiments, a magnetic alloy may be an alloy formed of one or more of: Pt, Pd, W, Ce, Al, Li, Mg, Na, Cr, Co, Dy, Er, Eu, Gd, Fe, Nd, K, Pr, Sm, Tb, Tm, or V. In some embodiments, a magnetic alloy may include a cobalt-zirconium-tantalum alloy. In some embodiments, suitable ferrite materials may include any of nickel, manganese, zinc, and/or cobalt cations, in addition to iron. In some embodiments, suitable magnetic materials may include semiconducting or semi-metallic Heusler compounds. In some embodiments, suitable Heusler compounds may include any of manganese, iron, cobalt, molybdenum, nickel, copper, vanadium, indium, aluminum, gallium, silicon, germanium, tin, and/or antimony. In some embodiments, suitable magnetic materials may include a Heusler alloy, where the Heusler alloy is a material which includes one or more of: Cu₂MnAl, Cu₂MnIn, Cu₂MnSn, Ni₂MnAl, Ni₂MnIn, Ni₂MnSn, Ni₂MnSb, Ni₂MnGa Co₂MnAl, Co₂MnSi, Co₂MnGa, Co₂MnGe, Pd₂MnAl, Pd₂MnIn, Pd₂MnSn, Pd₂MnSb, Co₂FeSi, Co₂FeAl, Fe₂VAl, Mn₂VGa, Co₁FeGe, MnGa, MnGaRu, or Mn₃X, where 'X' is one of Ga or Ge.

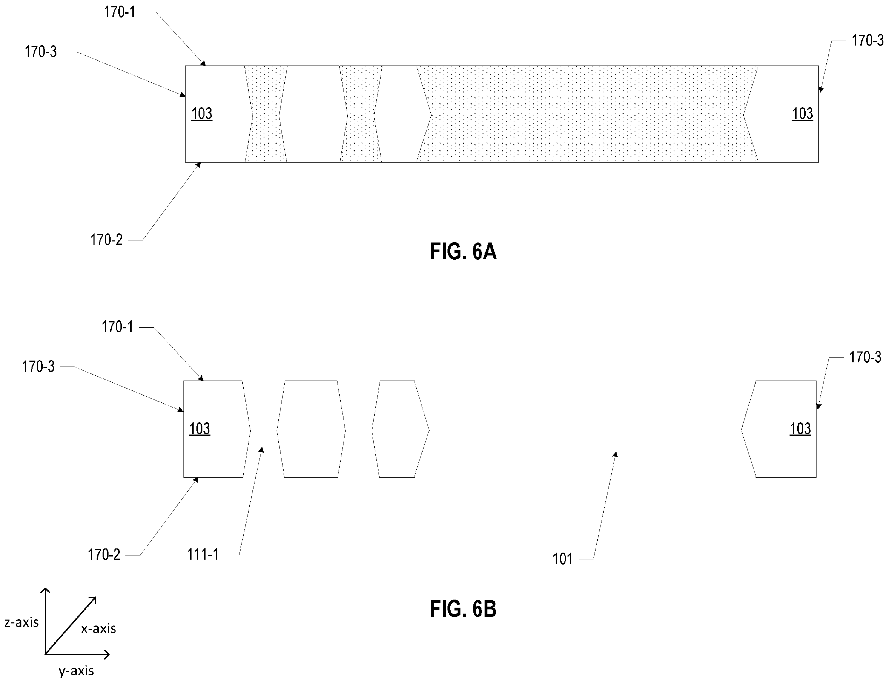

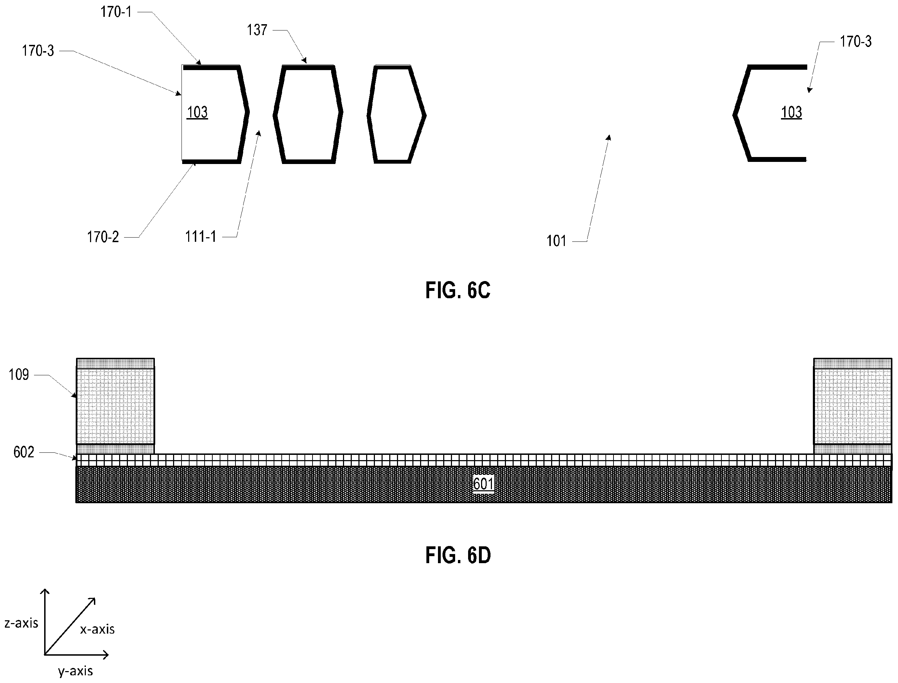

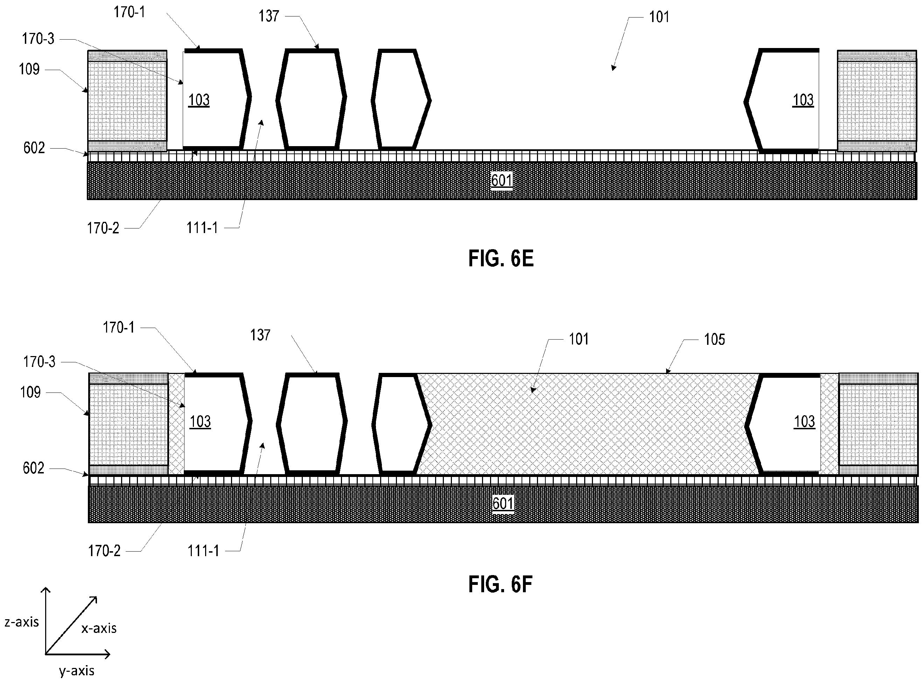

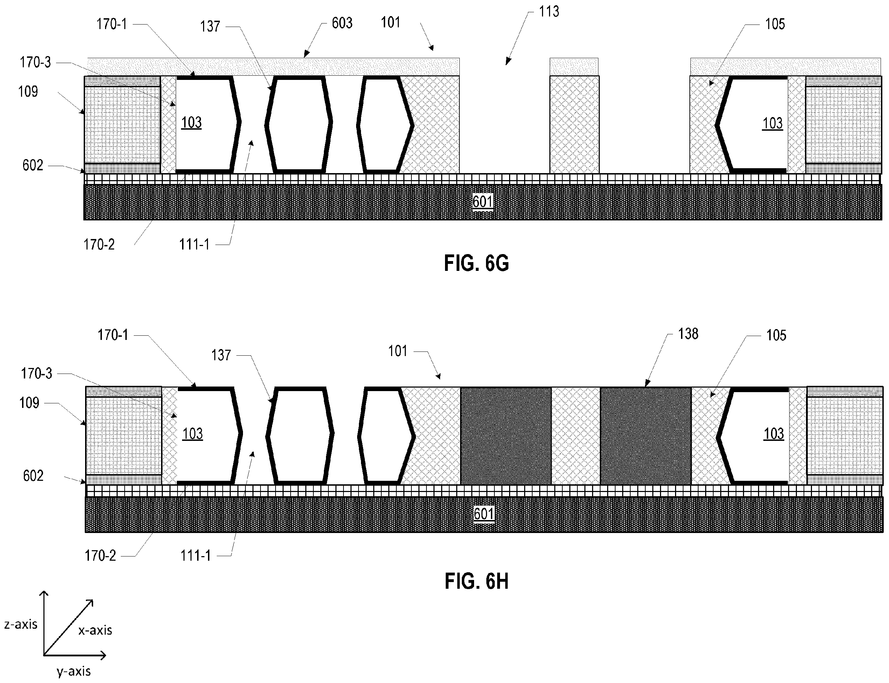

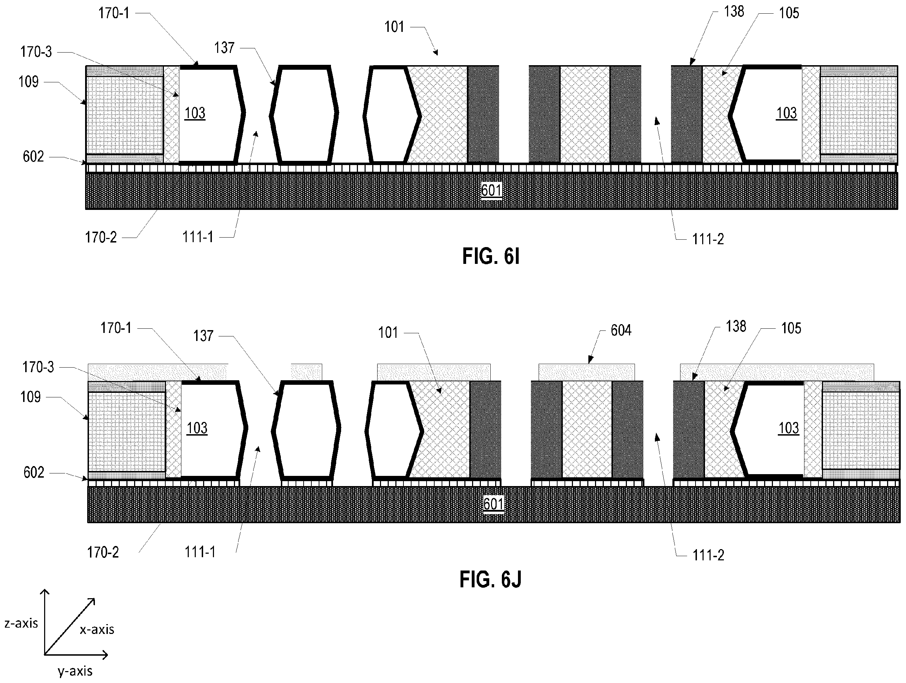

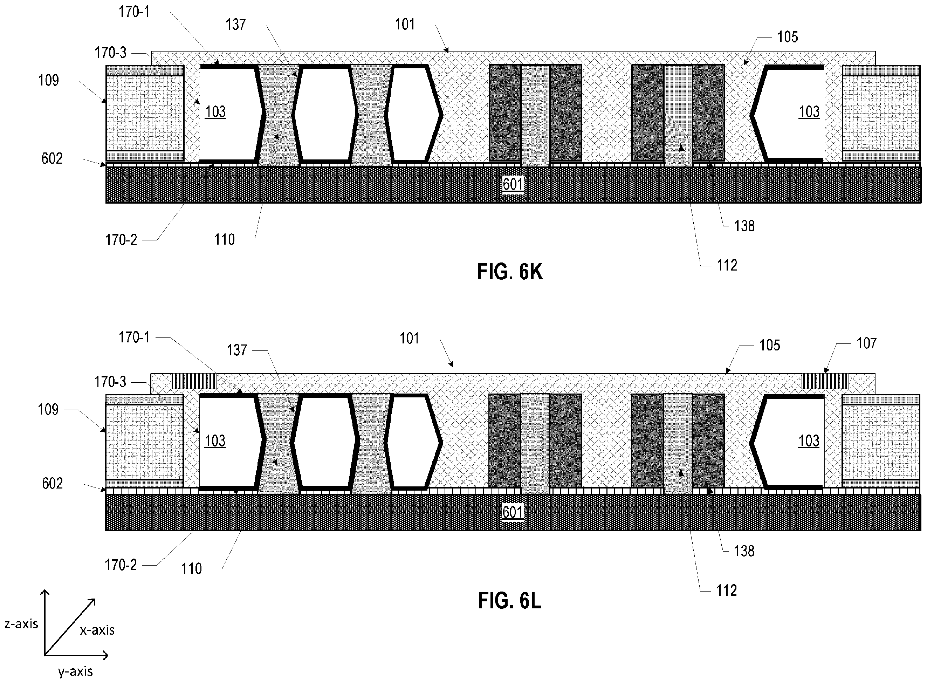

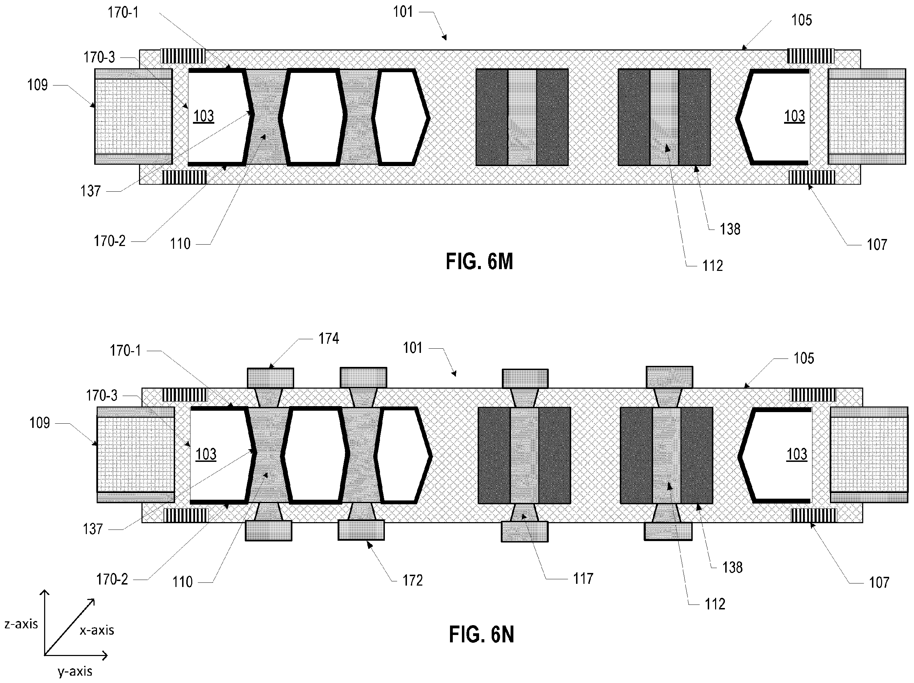

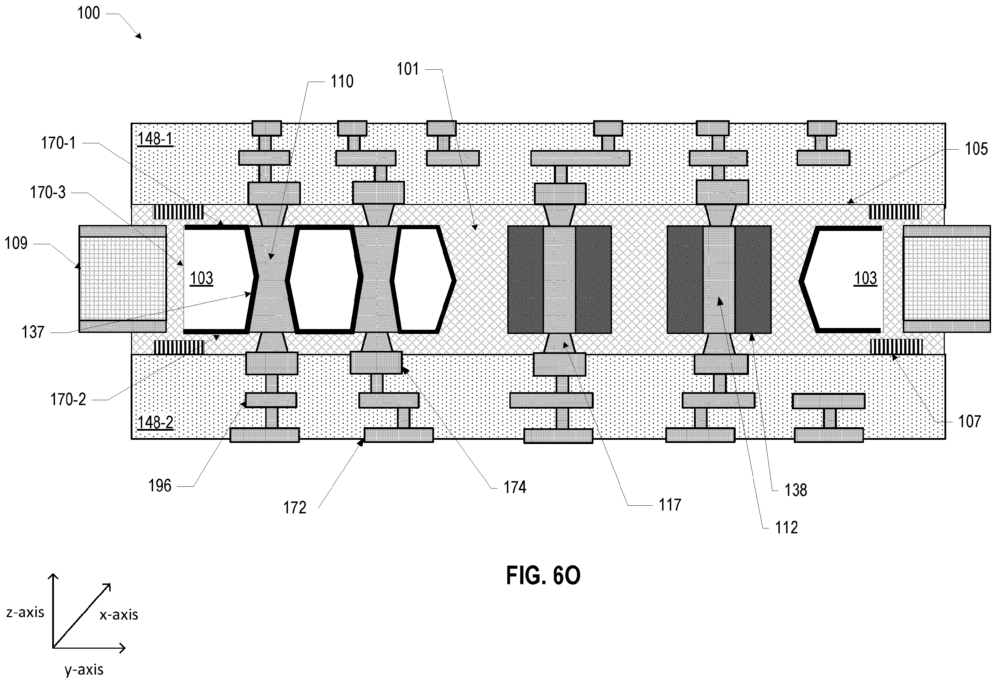

The microelectronic assembly 100 may also include a reinforcing material 107 on the encapsulating material 105 at the top surface 170-1 and the bottom surface 170-2 along one or more of the sides 170-3 of the glass layer 103. The reinforcing material 107 may include any suitable material, such as a Glass Cloth Prepreg (GCP) material or a Resin Coated Copper (RCC) material, that provides stability and support to the glass layer 103 at the side edges. The reinforcing material 107 may be formed using any suitable process, as described below with reference to FIG. 6. In some embodiments, the reinforcing material 107 in a microelectronic assembly 100 may be omitted, as described below with reference to FIG. 5.

The microelectronic assembly 100 may further include a first RDL 148-1 at the first surface 170-1 of the glass layer 103 and a second RDL 148-2 at the second surface 170-2 of the glass layer 103. The first and second RDLs 148-1, 148-2 may include conductive pathways 196 (e.g., including conductive traces and/or conductive vias, as shown) through a dielectric material. The RDLs 148 may include a set of first conductive contacts 172 on the bottom surface of the RDL 148 and a set of second conductive contacts 174 on the top surface of the RDL 148, where the conductive pathways 196 electrically couple individual ones of the first and second conductive contacts 172, 174. The first and second RDLs 148-1, 148-2 may be manufactured using any suitable technique, such as a PCB technique or a redistribution layer technique. In some embodiments, a dielectric material of the RDL 148 may include bismaleimide triazine (BT) resin, polyimide materials, epoxy materials (e.g., glass reinforced epoxy matrix materials, epoxy build-up films, or the like), mold materials, oxide-based materials (e.g., silicon dioxide or spin on oxide), or low-k and ultra low-k dielectric (e.g., carbon-doped dielectrics, fluorine-doped dielectrics, porous dielectrics, and organic polymeric dielectrics). The one or more through-vias may electrically couple the first and second RDLs 148-1, 148-2 (e.g., through the TGVs 110 or TDVs 112 and the conductive vias 117 in the encapsulating material 105). As used herein, the glass layer 103 with the first RDL 148-1 and/or the second RDL 148-2 may be referred to as a package substrate.

The microelectronic assembly 100 may further include die 114 electrically coupled to a top surface of the first RDL 148-1 by interconnects 150. In particular, conductive contacts 122 on a bottom surface of die 114 may be electrically and mechanically coupled to conductive contacts 174 at a top surface of the first RDL 148-1 by interconnects 150. Interconnects 150 disclosed herein may take any suitable form, including solder balls for a ball grid array arrangement, pins in a pin grid array arrangement or lands in a land grid array arrangement. In some embodiments, a set of interconnects 150 may include solder 132 (e.g., solder bumps or balls that are subject to a thermal reflow to form the interconnects 150). Interconnects 150 that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, a set of interconnects 150 may include an anisotropic conductive material, such as an anisotropic conductive film or an anisotropic conductive paste. An anisotropic conductive material may include conductive materials dispersed in a non-conductive material. In some embodiments, an anisotropic conductive material may include microscopic conductive particles embedded in a binder or a thermoset adhesive film (e.g., a thermoset biphenyl-type epoxy resin, or an acrylic-based material). In some embodiments, the conductive particles may include a polymer and/or one or more metals (e.g., nickel or gold). For example, the conductive particles may include nickel-coated gold or silver-coated copper that is in turn coated with a polymer. In another example, the conductive particles may include nickel. When an anisotropic conductive material is uncompressed, there may be no conductive pathway from one side of the material to the other. However, when the anisotropic conductive material is adequately compressed (e.g., by conductive contacts on either side of the anisotropic conductive material), the conductive materials near the region of compression may contact each other so as to form a conductive pathway from one side of the film to the other in the region of compression. In some embodiments, interconnects 150 disclosed herein may have a pitch between about 18 microns and 75 microns.

The die 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). The conductive pathways in the die 114 may be bordered by liner materials, such as adhesion liners and/or barrier liners, as suitable. In some embodiments, the die 114 is a wafer. In some embodiments, the die 114 is a monolithic silicon, a fan-out or fan-in package die, or a die stack (e.g., wafer stacked, die stacked, or multi-layer die stacked). In various embodiments, die 114 may include, or be a part of, one or more of a central processing unit (CPU), a memory device (e.g., a high-bandwidth memory device), a logic circuit, input/output circuitry, a transceiver such as a field programmable gate array transceiver, a gate array logic such as a field programmable gate array logic, of a power delivery circuitry, a III-Vor a III-N device such as a III-N or III-N amplifier (e.g., GaN amplifier), Peripheral Component Interconnect Express (PCIe) circuitry, Double Data Rate (DDR) transfer circuitry, or other electronic components known in the art.

The microelectronic assembly 100 of FIG. 1 may also include an insulating material 133 that encapsulates the die 114 (e.g., on and around die 114 and interconnects 150). The insulating material 133 may extend from a top surface of the first RDL 148-1 to a top surface of the die 114. In some embodiments, the insulating material 133 may be a mold material, such as an organic polymer with inorganic silicon oxide or aluminum oxide particles, a resin material, or an epoxy material. In some embodiments (not shown) other components, such as heat sinks may be coupled to microelectronic assembly 100 based on particular needs.

The microelectronic assembly 100 of FIG. 1 may also include an underfill material 127. In some embodiments, the underfill material 127 may extend between die 114 and the first RDL 148-1 around the associated interconnects 150. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering die 114 to the first RDL 148-1 when forming the interconnects 150, and then polymerizes and encapsulates the interconnects 150. The underfill process may include dispensing underfill material in liquid form, allowing the material to flow and fill the interstitial gaps around interconnects 150, and subjecting the assembly to a curing process, such as baking, to solidify the material. In some embodiments, an underfill material 127 may be omitted. The underfill material 127 may be selected to have a coefficient of thermal expansion (CTE) that may mitigate or minimize the stress between die 114 and the second RDL 148-2 arising from uneven thermal expansion in the microelectronic assembly 100. In some embodiments, the CTE of the underfill material 127 may have a value that is intermediate to the CTE of the first RDL 148-1 (e.g., the CTE of the dielectric material of the RDL 148) and a CTE of the insulating material of die 114.

The microelectronic assembly 100 of FIG. 1 may also include a circuit board 131. In particular, conductive contacts 172 on a bottom surface of the first RDL 148-1 may be electrically coupled to conductive contacts 146 on a top surface of circuit board 131 by interconnects 190. Interconnects 190 disclosed herein may take any suitable form, including any of the forms described above with reference to interconnects 150. As shown in FIG. 1, in some embodiments, a set of interconnects 190 may include solder 136 (e.g., solder bumps or balls that are subject to a thermal reflow to form the interconnects 190). In some embodiments, the interconnects 190 disclosed herein may have a pitch between about 50 microns and 300 microns. In some embodiments, an underfill material 127 may extend between the second RDL 148-2 and the circuit board 131 around the associated interconnects 190. The circuit board 131 may be a motherboard, for example, and may have other components attached to it. The circuit board may include conductive pathways and other conductive contacts for routing power, ground, and signals through the circuit board, as known in the art. In some embodiments, the interconnects 190 may not couple to a circuit board 131, but may instead couple to another IC package, an interposer, or any other suitable component.

In some embodiments, one or more levels of solder resist (e.g., epoxy liquid, liquid photoimageable polymers, dry film photoimageable polymers, acrylics, solvents) may be provided in an IC package described herein and may not be labeled or shown to avoid cluttering the drawings. Solder resist may be a liquid or dry film material including photoimageable polymers. In some embodiments, solder resist may be non-photoimageable.

Many of the elements of the microelectronic assembly 100 of FIG. 1 are included in other ones of the accompanying figures; the discussion of these elements is not repeated when discussing these figures, and any of these elements may take any of the forms disclosed herein. Various elements shown in the microelectronic assembly 100 of FIG. 1 are not included in the other ones of the accompanying figures to reduce cluttering the figures; however, the omitted elements may be included in the microelectronic assemblies 100 in these figures.

FIG. 2 is a schematic cross-sectional view of another example microelectronic assembly according to some embodiments of the present disclosure. The configuration of the embodiment shown in the figure is like that of FIG. 1, except for differences as described further. The configuration of microelectronic assembly 100 as described herein further includes a liner material 137. The liner material 137 may be between a material of the glass layer 103 and a conductive material of the TGV 110, and may further include a space between the liner material 137 and the conductive material of the TGV 110 (e.g., the conductive material of the TGV 110 is not attached (i.e., not physically coupled) to the liner material 137), as described above with reference to FIG. 1. The liner material 137 may further be on the top and bottom surfaces 170-1, 170-2 and in the cavity 101 of the glass layer 103 between the material of the glass layer 103 and the encapsulating material 105. The liner material 137 may function as a buffer layer to further reduce stress from the expansion and contraction of the conductive material of the TGV 110 on the glass layer 103. The liner material 137 may include any suitable material, such as parylene; silicon and nitrogen (e.g., in the form of silicon nitride); silicon, oxygen, and nitrogen (e.g., in the form of silicon oxynitride); silicon, oxygen, and carbon (e.g., in the form of silicon oxycarbide); silicon and oxygen (e.g., in the form of silicon oxide); or a polyimide. The liner material 137 may have any suitable dimensions, for example, the liner material 137 may have a thickness (e.g., z-height on top and bottom surface 170-1, 170-2 or a width (e.g., y-dimension on a side of the TGV 110) of between 10 nanometers and 10 microns.

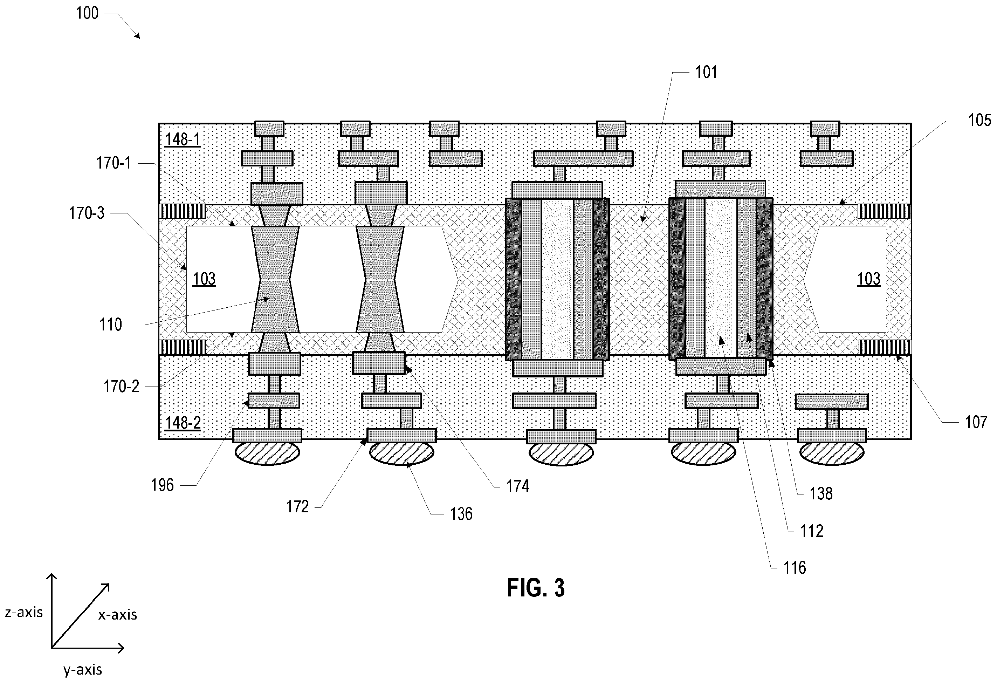

FIG. 3 is a schematic cross-sectional view of another example microelectronic assembly according to some embodiments of the present disclosure. The configuration of the embodiment shown in the figure is like that of FIG. 1, except for differences as described further. The configuration of microelectronic assembly 100 as described herein further includes a plug 116 through the conductive material of the TDV 112 and the TDV 112 extends fully through the encapsulating material 105 to electrically couple to first conductive contact 172 at the bottom of the first RDL 148-1 and to second conductive contact 174 at the top of the second RDL 148-2 (e.g., the conductive via 117, as shown in FIG. 1, is omitted). A material of the plug 116 may include any suitable material, including a plugging resin that is commonly used in organic substrate fabrication. The conductive material of the TDV 112 around the plug 116 may have a width (e.g., y-dimension) between 10 microns and 30 microns (e.g., between 15 microns and 20 microns).

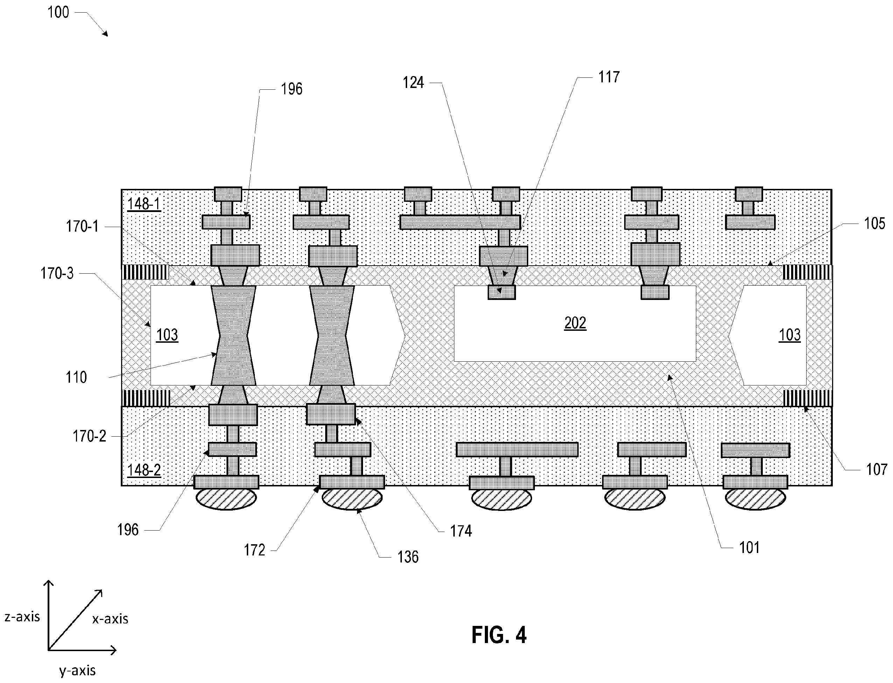

FIG. 4 is a schematic cross-sectional view of another example microelectronic assembly according to some embodiments of the present disclosure. The configuration of the embodiment shown in the figure is like that of FIG. 1, except for differences as described further. The configuration of microelectronic assembly 100 as described herein further includes passive component 202 in the cavity 101 surrounded by the encapsulating material 105. The passive component 202 may include appropriate circuitry for enhanced power delivery. In some embodiments, passive component 202 may include a discrete inductor or a discrete capacitor.

Although FIGS. 1-4 illustrate a particular number and arrangement of elements, a microelectronic assembly 100 may include any number and arrangement of elements, including, for example, more than two TGVs 110, more than two TDVs 112, more than two die 114, more than one passive component 202, and any combination of these elements.

FIGS. 5A and 5B are simplified cross-sectional views illustrating example microelectronic assemblies during manufacturing and prior to singulation according to some embodiments of the present disclosure. FIGS. 5A and 5B show three, side-by-side, glass layers 103 including TGVs 110 and TDVs 112 with a magnetic material 138 (e.g., as shown in FIG. 1) in a frame 109 and surrounded by an encapsulating material 105. The frame 109 may include any suitable material, such as described below with reference to FIG. 6. The frame 109 may be along a perimeter of the three, side-by-side, glass layers 103 and the encapsulating material 105 may be between the frame 109 and the sides 170-3 of the glass layer 103 adjacent to the frame 109. A reinforcing material 107 may be along the perimeter of the frame 109 on the encapsulating material 105 at the top and bottom surfaces 170-1, 170-2 of the glass layer 103. The reinforcing material 107 may provide rigidity and stability between the glass layer 103 and the frame 109. As shown in FIG. 5A, the reinforcing material 107 only may be along the perimeter of the frame 109, such that, when the glass layers 103 are singulated at the saw streets 510, the reinforcing material 107 may not be at all sides 170-3 of the glass layer 103 and, for the glass layer 103 in the middle, the reinforcing material 107 may be omitted. As shown in FIG. 5B, the reinforcing material 107 may frame each individual glass layer 103 (e.g., similar to a windowpane) such that, when the glass layers are singulated at the saw streets 510, the reinforcing material 107 may be at all sides 170-3 of the glass layer 103.

Any suitable techniques may be used to manufacture the microelectronic assemblies 100 disclosed herein. For example, FIGS. 6A-6O are side, cross-sectional views of various stages in an example process for manufacturing the microelectronic assembly 100 of FIG. 2, in accordance with various embodiments. Although the operations discussed below with reference to FIGS. 6A-6O (and others of the accompanying drawings representing manufacturing processes) are illustrated in a particular order, these operations may be performed in any suitable order. Further, additional operations which are not illustrated may also be performed without departing from the scope of the present disclosure. Also, various ones of the operations discussed herein with respect to FIGS. 6A-6O and the other example processes for manufacturing may be modified in accordance with the present disclosure to fabricate others of microelectronic assembly 100 disclosed herein.

FIG. 6A illustrates a glass layer 103 having a top surface 170-1, an opposing bottom surface 170-2, and side surfaces 170-3 perpendicular to the top and bottom surfaces 170-1, 170-2 subsequent to exposing the glass layer 103 to a laser for patterning (e.g., laser ablation using excimer laser), as indicated by the shaded areas.

FIG. 6B illustrates the glass layer 103 subsequent to removing laser-exposed portions of the glass layer 103 to form a via opening 111-1 and a cavity 101. The laser-exposed portions may be removed using any suitable process, including chemical etching. Although FIGS. 6A and 6B illustrate via openings 111-1 and cavity 101 being formed using a laser process, any suitable process may be used including, for example, lithography or plasma etching.

FIG. 6C illustrates an assembly subsequent to depositing a liner material 137 on the glass layer 103 of FIG. 6B (e.g., on a top surface 170-1, on a bottom surface 170-2 and in the via openings 111-1 and cavity 101 of the glass layer 103. The liner material 137 may include any suitable material, as described above with reference to FIG. 2, and may be formed using any suitable process, including physical vapor deposition (PVD), atomic layer deposition (ALD), plasma enhanced chemical vapor deposition (PECVD) or chemical vapor deposition (CVD). The liner material 137 may have any suitable dimensions, as described above with reference to FIG. 2. In some embodiments, the liner material 137 may be omitted.

FIG. 6D illustrates a carrier 601 and a frame 109 attached to a surface of the carrier 601 by a temporary bonding material 602 (e.g., a removable adhesive). The carrier 601 may include any suitable material for providing mechanical stability during manufacturing operations, such as a copper carrier. The frame 109 may include any suitable material for providing mechanical stability during manufacturing operations, and, as shown, may include a prepreg organic core with a copper clad layer (CCL) material on a top surface and a bottom surface. In some embodiments, the CCL material may be omitted.

FIG. 6E illustrates an assembly subsequent to placing the glass layer 103 of FIG. 6C within the frame 109 and attaching the glass layer 103 of FIG. 6B to the carrier 601 by the temporary bonding material 602. Although FIG. 6E illustrates a single glass layer 103, the assembly of FIG. 6E may include a plurality of glass layers 103 within the frame 109, as shown above with reference to FIG. 5.

FIG. 6F illustrates an assembly subsequent to depositing an encapsulating material 105 in the cavity 101 and in the gaps between the frame 109 and the side surfaces 170-3 of the glass layer 103. The encapsulating material 105 may be deposited using any suitable technique, including lamination or dispensing and curing, and may be formed in multiple layers to achieve a desired thickness. In some embodiments, a top surface of the encapsulating material 105 may be planarized (e.g., by grinding or by chemical and mechanical polishing (CMP)) to remove excess material and be flush with the top surface 170-1 of the glass layer 103.

FIG. 6G illustrates an assembly subsequent to forming openings 113 through the encapsulating material 105 in the cavity 101. The openings 113 may be formed using any suitable technique, including depositing a mask material 603 and using a plasma/dry etch process to remove the encapsulating material 105.

FIG. 6H illustrates an assembly subsequent to removing the mask material 603 and to depositing a magnetic material 138 in the openings 113 of the assembly of FIG. 6G. The magnetic material 138 may include any suitable material, as described above with reference to FIG. 1, and may be formed using any suitable process, including squeezy printing of an epoxy resin medium with magnetic particles. In some embodiments, a top surface of the magnetic material 137 may be planarized (e.g., by grinding) to remove excess material and be flush with the top surface 170-1 of the glass layer 103.

FIG. 6I illustrates an assembly subsequent to forming a via opening 111-2 through the magnetic material 138 of the assembly of FIG. 6H. The via opening 111-2 may be formed using any suitable technique, such as mechanical drilling.

FIG. 6J illustrates an assembly subsequent to removing exposed portions of the temporary bonding material 602 (e.g., at a bottom of the via openings 111-1, 111-2). The exposed portions of the temporary bonding material 602 may be removed using any suitable technique, including depositing a mask material 604 and using a plasma/dry etch process to remove the temporary bonding material 602.

FIG. 6K illustrates an assembly subsequent to removing the mask material 604 and depositing a conductive material in the via openings 111-1, 111-2 of the assembly of FIG. 6J to form TGV 110 and TDV 112. The conductive material may be deposited using any suitable process, such as electroplating. The conductive material may include any suitable material, as described above with reference to FIG. 1.

FIG. 6L illustrates an assembly subsequent to depositing an encapsulating material 105 and a reinforcing material 107 on a top surface 170-1 of the glass layer 103 of the assembly of FIG. 6K. The encapsulating material 105 and reinforcing material 107 may be deposited using any suitable technique, including lamination. In some embodiments, the encapsulating material 105 and the reinforcing material 107 may be laminated in a single operation. The reinforcing material 107 may be along a perimeter of the frame 109 (e.g., as shown above with reference to FIG. 5A), or may be along a perimeter of individual glass layers 103 (e.g., forming a windowpane, as shown above with reference to FIG. 5B).

FIG. 6M illustrates an assembly subsequent to removing the carrier 601 and the temporary bonding material 602 and depositing an encapsulating material 105 and a reinforcing material 107 on a bottom surface 170-2 of the glass layer 103 of the assembly of FIG. 6L. The encapsulating material 105 and reinforcing material 107 may be deposited using any suitable technique, including as described above with reference to FIG. 6L.

FIG. 6N illustrates an assembly subsequent to forming conductive vias 117 through the encapsulating material 105 at the top surface 170-1 and the bottom surface 170-2 of the glass layer 103 and forming second conductive contacts 174 electrically coupled to the conductive vias 117 at the top surface and first conductive contacts 172 electrically coupled to the conductive vias 117 at the bottom surface. The conductive vias 117 and conductive contacts 174, 172 may be formed using any suitable technique, including patterning via openings using lithography, laser drilling (e.g., laser ablation using excimer laser), or plasma etching, and depositing a conductive material in the via openings using any suitable process, including lithography, electrolytic plating, or electroless plating.

FIG. 6O illustrates an assembly subsequent to forming a first RDL 148-1 and a second RDL 148-2 on top and bottom surfaces, respectively, of the assembly of FIG. 6N. The RDL 148 may include conductive pathways 196 between first conductive contacts 172 on a bottom surface and second conductive contacts 174 on a top surface of the RDL 148. The RDL 148 may be manufactured using any suitable technique, such as a PCB technique or a redistribution layer technique. The assembly of FIG. 6O may be separated from the frame 109 by singulating (e.g., separating by sawing at the saw streets, as shown in FIG. 5). Further operations may be performed on the assembly of FIG. 6O. For example, electrically coupling the die 114 to the first RDL 148-1 by forming interconnects 150 and overmolding the die 114 with an insulating material 133, depositing solder 136 on a bottom surface of conductive contacts 172 of the second RDL 148-2, and/or electrically coupling solder 136 to a circuit board 131 to form interconnects 190, similar to the microelectronic assembly 100 of FIG. 1.

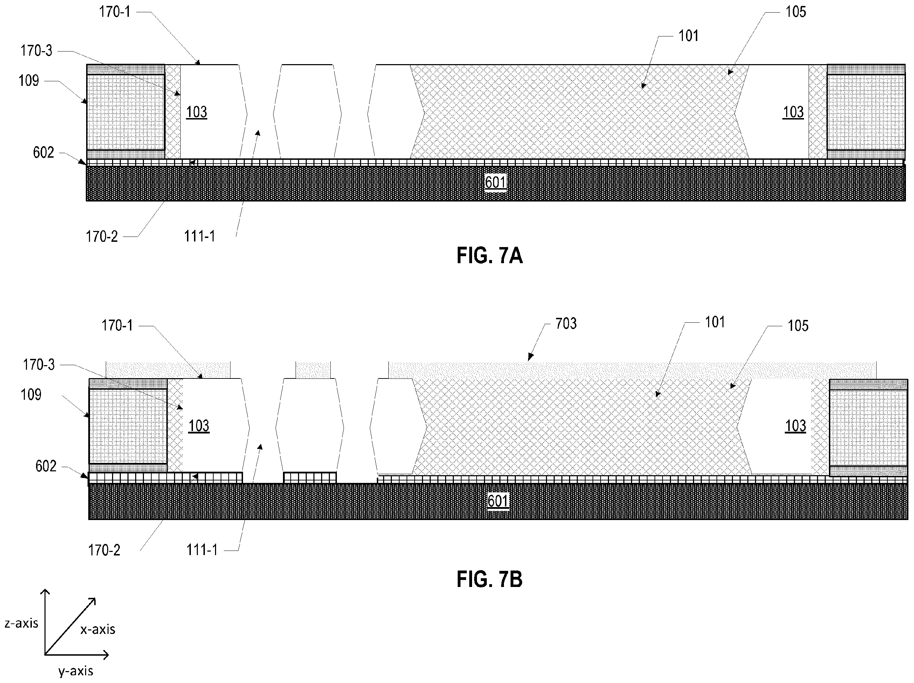

FIGS. 7A-7J are side, cross-sectional views of various stages in an example process for manufacturing the microelectronic assembly 100 of FIG. 3, in accordance with various embodiments.

FIG. 7A illustrates the assembly of FIG. 6F without the liner material 137. The assembly of 7A may be formed by operations described above with reference to FIGS. 6A, 6B, and 6D-6F.

FIG. 7B illustrates an assembly subsequent to removing exposed portions of the temporary bonding material 602 at a bottom of the via openings 111-1. The exposed portions of the temporary bonding material 602 may be removed using any suitable technique, including depositing a mask material 703 and using a plasma/dry etch process to remove the temporary bonding material 602.

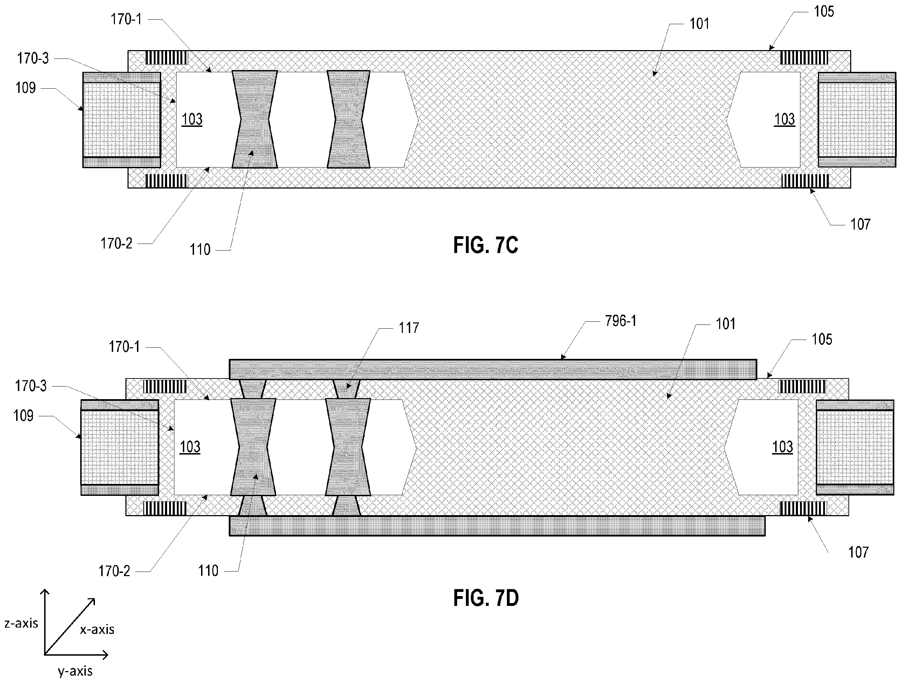

FIG. 7C illustrates an assembly subsequent to depositing a conductive material in the via openings 111-1 to form TGV 110, depositing an encapsulating material 105 and a reinforcing material 107 on a top surface 170-1 of the glass layer 103, removing the carrier 601 and temporary bonding material 602, and depositing an encapsulating material 105 and a reinforcing material 107 on a bottom surface 170-2 of the glass layer 103 of the assembly of FIG. 7B. The assembly of FIG. 7C may be formed as described above with reference to FIGS. 6K-6M.

FIG. 7D illustrates an assembly subsequent to forming conductive vias 117 through the encapsulating material 105 at the top surface 170-1 and the bottom surface 170-2 of the glass layer 103 and forming a first conductive layer 796-1 at a top surface and a bottom surface of the assembly of FIG. 7C. The conductive vias 117 and first conductive layers 796-1 may be formed as described above with reference to FIG. 6N.

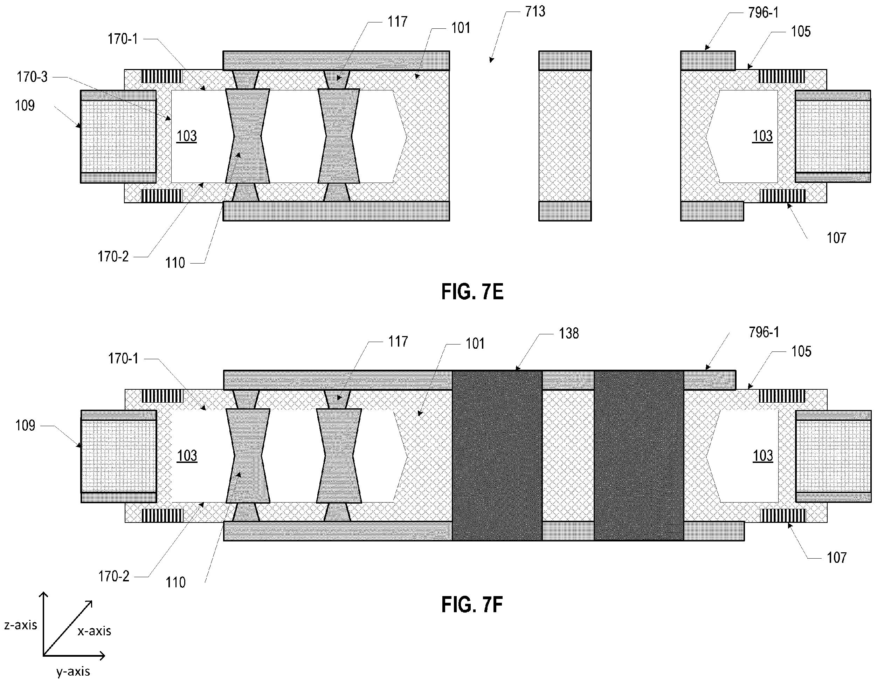

FIG. 7E illustrates an assembly subsequent to forming an opening 713 through the encapsulating material in the cavity 101 and the first conductive layers 796-1 at the top and bottom surfaces. The openings 713 may be formed using any suitable technique, including mechanical drilling.

FIG. 7F illustrates an assembly subsequent to depositing a magnetic material 138 in the openings 113 of the assembly of FIG. 7E. The magnetic material 138 may include any suitable material, as described above with reference to FIG. 1, and may be formed using any suitable process, including as described above with reference to FIG. 6H.

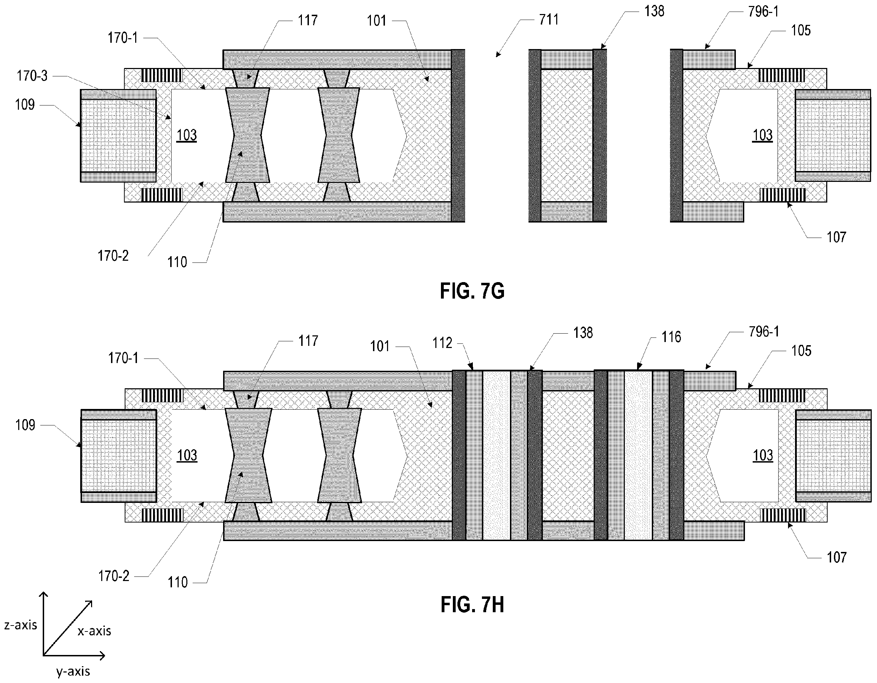

FIG. 7G illustrates an assembly subsequent to forming a via opening 711 through the magnetic material 138 of the assembly of FIG. 7F. The via opening 711 may be formed using any suitable technique, such as mechanical drilling.

FIG. 7H illustrates an assembly subsequent to plating a conductive material in the opening 711 in FIG. 7G to form TDV 112 and forming a plug 116 in the plated conductive material forming TDV 112. The conductive material may include any suitable conductive material as described above with reference to FIG. 1, and may be deposited using any suitable technique, including electroplating. The plug 116 may be formed using any suitable material, as described above with reference to FIG. 3, and may be deposited using any suitable technique, including squeezy printing for a flowable material or vacuum lamination for a film. In some embodiments, a top surface of the conductive material of the TDV 112 and/or the material of the plug 116 may be planarized (e.g., by grinding) to remove excess material and be flush with the respective top and bottom surfaces of the first conductive layers 796-1.

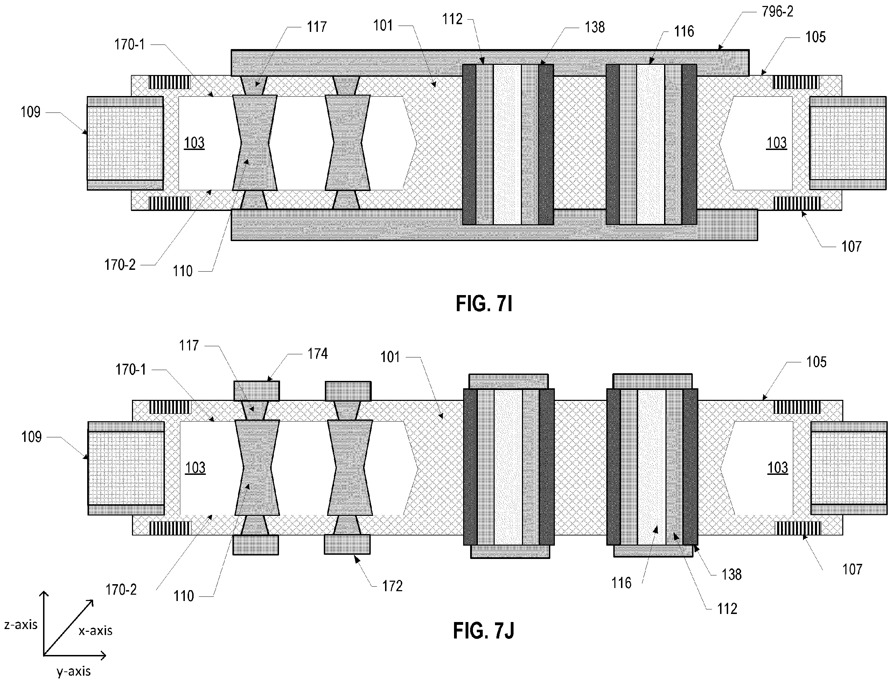

FIG. 7I illustrates an assembly subsequent to forming second conductive layers 796-2 on the first conductive layers 796-1 at a top surface and a bottom surface of the assembly of FIG. 7H. Second conductive layers 796-2 may be formed as described above with reference to first conductive layers 796-1 in FIG. 7D.

FIG. 7J illustrates an assembly subsequent to performing a selective etch to remove portions of the first and second conductive layers 796-1, 796-2 to form first conductive contacts 172 at a bottom surface of the assembly and second conductive contacts 172 at a top surface of the assembly. Further operations may be performed on the assembly of FIG. 7J, including forming a first RDL 148-1 and a second RDL 148-2 on top and bottom surfaces, respectively, electrically coupling the die 114 to the first RDL 148-1 by forminginterconnects 150 and overmolding the die 114 with an insulating material 133, depositing solder 136 on a bottom surface of conductive contacts 172 of the second RDL 148-2, and/or electrically coupling solder 136 to a circuit board 131 to form interconnects 190, similar to the microelectronic assembly 100 of FIG. 1. The assembly of FIG. 7J may be separated from the frame 109 by singulating (e.g., separating by sawing at the saw streets, as shown in FIG. 5).

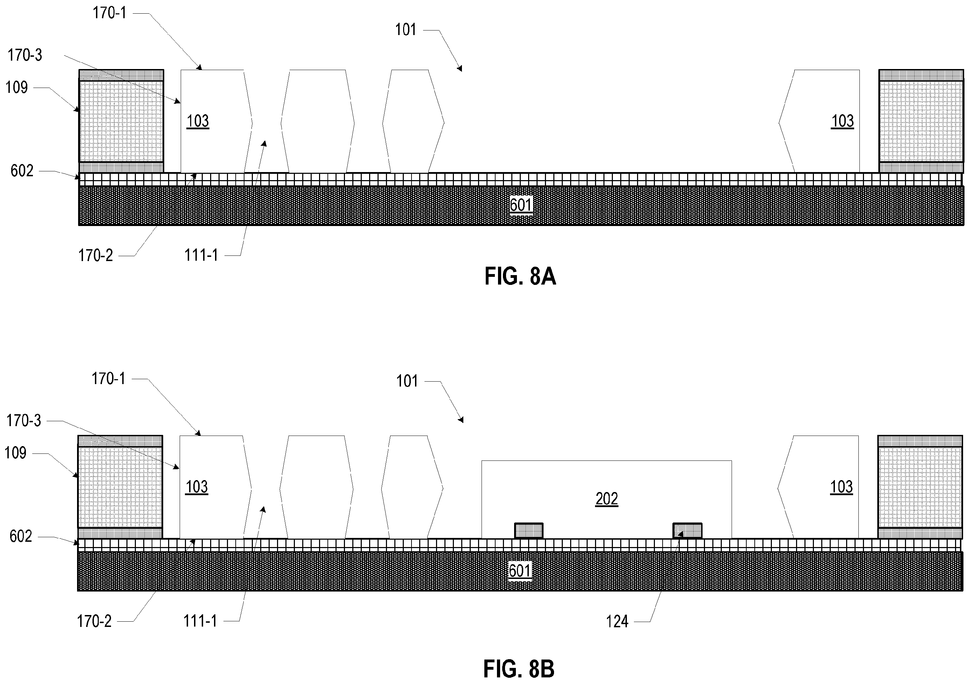

FIGS. 8A-8E are side, cross-sectional views of various stages in an example process for manufacturing the microelectronic assembly 100 of FIG. 4, in accordance with various embodiments.

FIG. 8A illustrates the assembly of FIG. 6E without the liner material 137. The assembly of 8A may be formed by operations described above with reference to FIGS. 6A, 6B, 6D, and 6E.

FIG. 8B illustrates an assembly subsequent to placing a passive component in the cavity 101 and attaching the passive component 202 to the carrier 601 by a temporary bonding material 602. The passive component 202 may be placed with conductive contacts 124 facing towards the carrier. Any suitable method may be used to place the passive component 202, for example, automated pick-and-place.

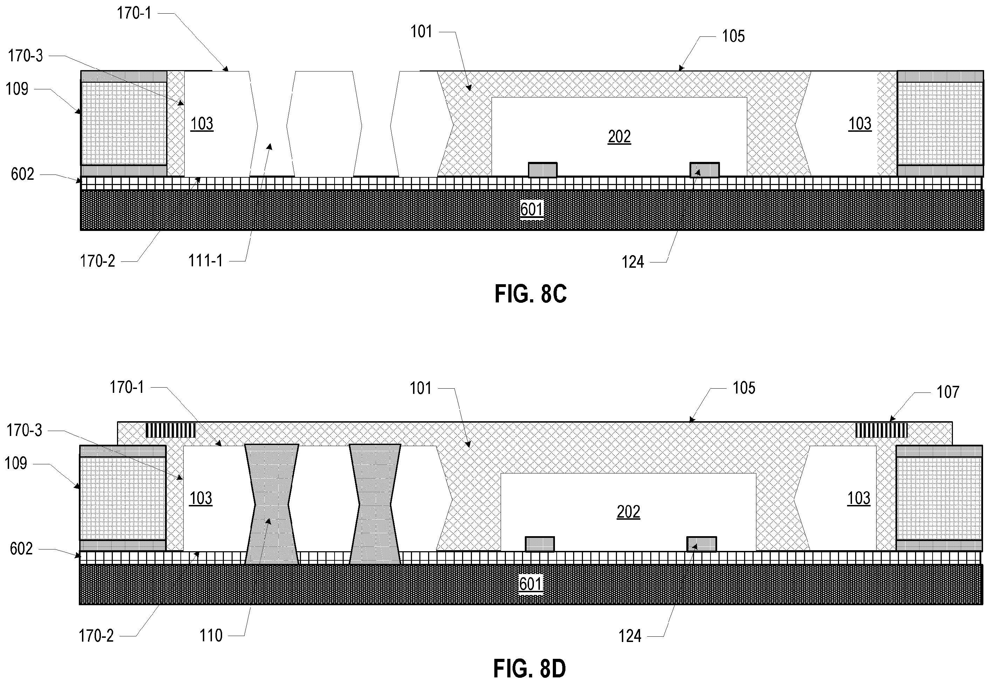

FIG. 8C illustrates an assembly subsequent to depositing an encapsulating material 105 in the cavity 101 around the passive component 202, and in the gaps between the frame 109 and the side surfaces 170-3 of the glass layer 103. The encapsulating material 105 may be deposited as described above with reference to FIG. 6F.

FIG. 8D illustrates an assembly subsequent to removing exposed portions of the temporary bonding material 602 at a bottom of the via openings 111-1, depositing a conductive material in the via openings 111-1 to form TGV 110, and depositing an encapsulating material 105 and a reinforcing material 107 on a top surface 170-1 of the glass layer 103. The assembly of FIG. 8D may be formed as described above with reference to FIGS. 6J-6L.

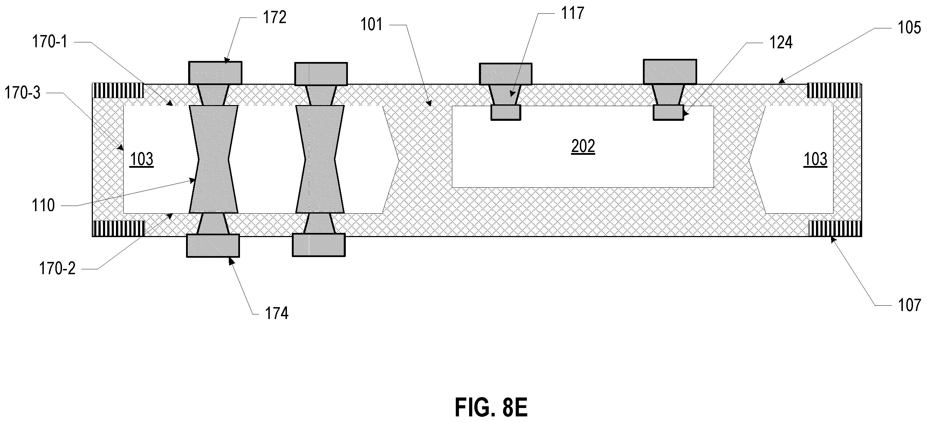

FIG. 8E illustrates an assembly subsequent to removing the carrier 601 and temporary bonding material 602, and depositing an encapsulating material 105 and a reinforcing material 107 on a bottom surface 170-2 of the glass layer 103 of the assembly of FIG. 8D, forming conductive vias 117 through the encapsulating material 105 at the top surface 170-1 and the bottom surface 170-2 of the glass layer 103, and inverting the assembly. Although FIG. 8E illustrates an assembly that has been removed (e.g., singulated along saw streets, as shown in FIG. 5) from the frame 109 (e.g., as shown in FIG. 8D), further operations may be performed to the assembly of FIG. 8E prior to singulation, including forming a first RDL 148-1 and a second RDL 148-2 on top and bottom surfaces, respectively, electrically coupling the die 114 to the first RDL 148-1 by forming interconnects 150 and overmolding the die 114 with an insulating material 133, depositing solder 136 on a bottom surface of conductive contacts 172 of the second RDL 148-2, and/or electrically coupling solder 136 to a circuit board 131 to form interconnects 190, similar to the microelectronic assembly 100 of FIG. 1.

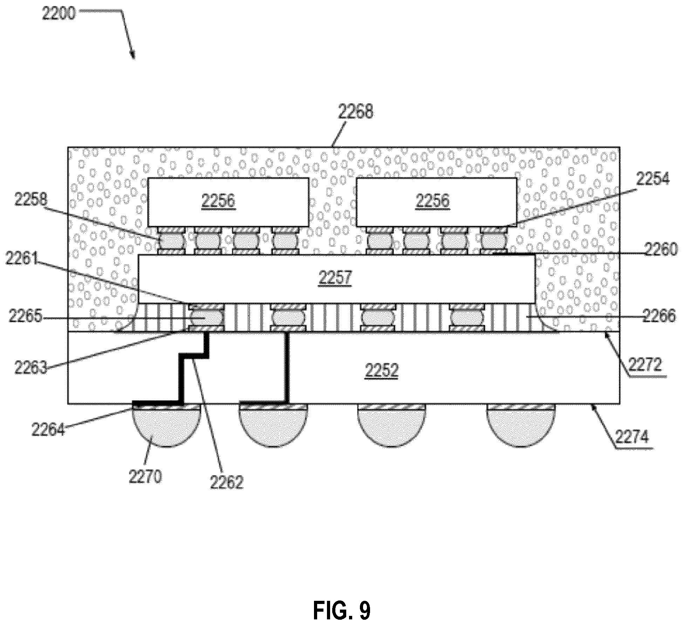

The packages disclosed herein, e.g., any of the microelectronic assemblies 100, or any further embodiments described herein, may be included in any suitable electronic component. FIGS. 9-11 illustrate various examples of packages, assemblies, and devices that may be used with or include any of the IC packages as disclosed herein.

FIG. 9 is a side, cross-sectional view of an example IC package 2200 that may include microelectronic assemblies in accordance with any of the embodiments disclosed herein. In some embodiments, the IC package 2200 may be a system-in-package (SiP).

As shown in FIG. 9, package support 2252 may be formed of an insulator (e.g., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures comprising lines and/or vias, e.g., as discussed above with reference to FIG. 1.

Package support 2252 may include conductive contacts 2263 that are coupled to conductive pathway 2262 through package support 2252, allowing circuitry within dies 2256 and/or interposer 2257 to electrically couple to various ones of conductive contacts 2264 (or to other devices included in package support 2252, not shown).

IC package 2200 may include interposer 2257 coupled to package support 2252 via conductive contacts 2261 of interposer 2257, first level interconnects (FLI) 2265, and conductive contacts 2263 of package support 2252. FLI 2265 illustrated in FIG. 9 are solder bumps, but any suitable FLI 2265 may be used, such as solder bumps, solder posts, or bond wires.

IC package 2200 may include one or more dies 2256 coupled to interposer 2257 via conductive contacts 2254 of dies 2256, FLI 2258, and conductive contacts 2260 of interposer 2257. In various embodiments, interposer 2257 may include glass layer 103 comprising glass as described herein. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). FLI 2258 illustrated in FIG. 9 are solder bumps, but any suitable FLI 2258 may be used, such as solder bumps, solder posts, or bond wires. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

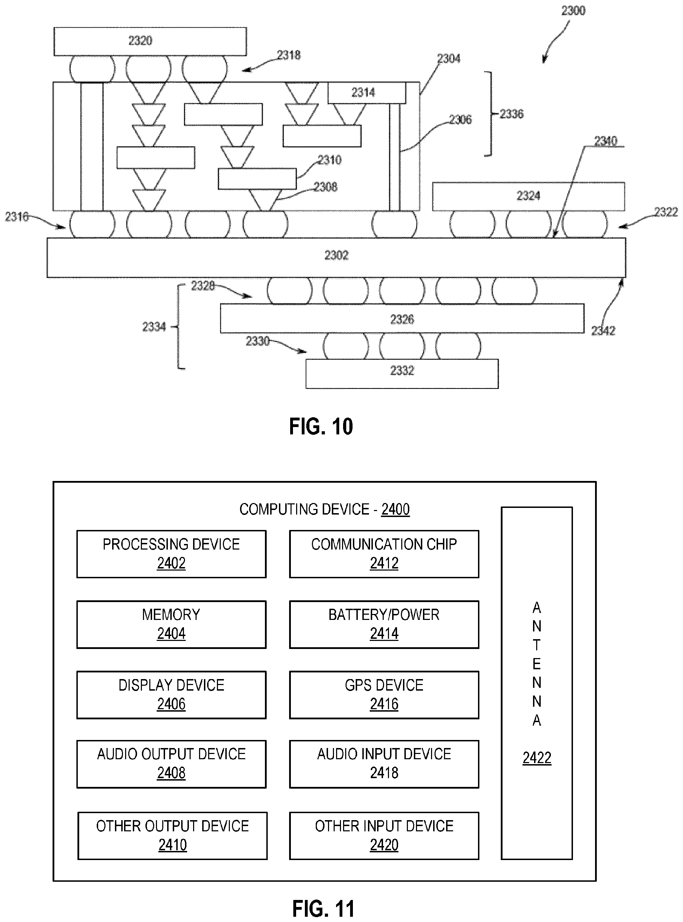

In some embodiments, underfill material 2266 may be disposed between package support 2252 and interposer 2257 around FLI 2265, and mold 2268 may be disposed around dies 2256 and interposer 2257 and in contact with package support 2252. In some embodiments, underfill material 2266 may be the same as mold 2268. Example materials that may be used for underfill material 2266 and mold 2268 are epoxies as suitable. Second level interconnects (SLI) 2270 may be coupled to conductive contacts 2264. SLI 2270 illustrated in FIG. 9 are solder balls (e.g., for a ball grid array (BGA) arrangement), but any suitable SLI 2270 may be used (e.g., pins in a pin grid array arrangement or lands in a land grid array arrangement). SLI 2270 may be used to couple IC package 2200 to another component, such as a circuit board (e.g., a motherboard), an interposer, or another IC package, as known in the art and as discussed below with reference to FIG. 11.

In embodiments in which IC package 2200 includes multiple dies 2256, IC package 2200 may be referred to as a multichip package (MCP). Dies 2256 may include circuitry to perform any desired functionality. For example, besides one or more of dies 2256 comprising components of dies 114 as described herein, one or more of dies 2256 may be logic dies (e.g., silicon-based dies), one or more of dies 2256 may be memory dies (e.g., high-bandwidth memory), etc. In some embodiments, at least some of dies 2256 may not include components of dies 114 as described herein.

Although IC package 2200 illustrated in FIG. 9 is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package support 2252, or on either face of interposer 2257. More generally, IC package 2200 may include any other active or passive components known in the art.

FIG. 10 is a cross-sectional side view of an IC device assembly 2300 that may include components having one or more microelectronic assembly 100 in accordance with any of the embodiments disclosed herein. IC device assembly 2300 includes a number of components disposed over a circuit board 2302 (which may be, e.g., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 100 in accordance with any of the embodiments disclosed herein; e.g., any of the IC packages discussed below with reference to IC device assembly 2300 may take the form of any of the embodiments of IC package 2200 discussed above with reference to FIG. 9.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package support.

FIG. 10 illustrates that, in some embodiments, IC device assembly 2300 may include a package-on-interposer structure 2336 coupled to first face 2340 of circuit board 2302 by coupling components 2316. Although not shown so as not to clutter the drawing, package-on-interposer structure 2336 may comprise a core, such as glass layer 103 in some embodiments. In other embodiments, package-on-interposer structure 2336 may not comprise a core. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. In some embodiments, IC package 2320 may comprise microelectronic assembly 100, including a strengthened glass layer 103, and other components as described herein, which are not shown so as not to clutter the drawing. Coupling components 2318 may take any suitable form depending on desired functionalities, such as the forms discussed above with reference to coupling components 2316. In some embodiments, IC package 2320 may be or include IC package 2200, e.g., as described above with reference to FIG. 9.

Although a single IC package 2320 is shown in FIG. 10, multiple IC packages may be coupled to interposer 2304; indeed, additional interposers may be coupled to interposer 2304. Interposer 2304 may provide an intervening package support used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in FIG. 10, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2308 and vias 2310, including TSVs 2306. Interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 11 is a block diagram of an example computing device 2400 that may include one or more components having one or more IC packages in accordance with any of the embodiments disclosed herein. For example, any suitable ones of the components of computing device 2400 may include microelectronic assembly 100 including a strengthened glass layer 103 comprising glass in accordance with any of the embodiments disclosed herein. In another example, any one or more of the components of computing device 2400 may include any embodiments of IC package 2200 (e.g., as shown in FIG. 9). In yet another example, any one or more of the components of computing device 2400 may include an IC device assembly 2300 (e.g., as shown in FIG. 10).

A number of components are illustrated in FIG. 11 as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single SOC die.

Additionally, in various embodiments, computing device 2400 may not include one or more of the components illustrated in FIG. 11, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (e.g., connectors and supporting circuitry) to which audio input device 2418 or audio output device 2408 may be coupled.

Computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more digital signal processors (DSPs), ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (e.g., one or more communication chips; note that the terms "chip," "die," and "IC die" are used interchangeably herein). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives of it, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (e.g., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (e.g., batteries or capacitors) and/or circuitry for coupling components of computing device 2400 to an energy source separate from computing device 2400 (e.g., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

The above description of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

The following paragraphs provide various examples of the embodiments disclosed herein.

Example 1 is a microelectronic assembly, including a glass layer having a first surface, an opposing second surface, and side surfaces extending between the first and second surfaces, the glass layer including a cavity; a material in the cavity and on the first, second, and side surfaces of the glass layer, wherein the material includes an organic dielectric, a mold material, an epoxy-based organic material, an epoxy material, or an epoxy material with silica fillers; a first via extending through the glass layer and through the material on the first and second surfaces of the glass layer, the first via including a conductive material; a second via extending through the material in the cavity, the second via including a conductive material surrounded by a magnetic material; and a dielectric layer on the material at the first surface of the glass layer, the dielectric layer including a first conductive pathway electrically coupled to the first via and a second conductive pathway electrically coupled to the second via.

Example 2 may include the subject matter of Example 1, and may further specify that a thickness of the material on the first surface or the second surface of the glass layer is between 5 microns and 100 microns.

Example 3 may include the subject matter of Example 1 or 2, and may further specify that a thickness of the material on the side surfaces of the glass layer is between 10 microns and 500 microns.

Example 4A may include the subject matter of any one of Examples 1-3, and may further include a space between the glass layer and the conductive material of the first via, where the space is between 50 nanometers and 200 nanometers.

Example 4B may include the subject matter of any one of Examples 1-3, and may further specify that the conductive material of the first via is not physically attached to the glass layer.

Example 5 may include the subject matter of any one of Examples 1-4, and may further specify that the magnetic material includes a ferromagnetic material.

Example 6 may include the subject matter of any one of Examples 1-5, and may further include a liner material on the first surface, on the second surface, and in the cavity between the glass layer and the material, and in the first via between the glass layer and the conductive material of the first via.

Example 7 may include the subject matter of Example 6, and may further specify that the liner material includes one or more of parylene; silicon and nitrogen; silicon, oxygen, and nitrogen; silicon, oxygen, and carbon; silicon and oxygen; or a polyimide.

Example 8 may include the subject matter of any one of Examples 1-7, and may further include a reinforcing material on the material at the first surface and the second surface of the glass layer along at least one of the side surfaces of the glass layer.

Example 9 may include the subject matter of Example 8, and may further specify that the reinforcing material includes Glass Cloth Prepreg (GCP) material or a Resin Coated Copper (RCC) material.

Example 10 may include the subject matter of Example 8 or 9, and may further specify that the reinforcing material is along at least two of the side surfaces of the glass layer.

Example 11 may include the subject matter of any one of Examples 1-10, and may further include a die electrically coupled to the first conductive pathway or the second conductive pathway in the dielectric layer.

Example 12 may include the subject matter of any one of Examples 1-11, and may further specify that the dielectric layer is a first dielectric layer including the first conductive pathway and the second conductive pathway, and the microelectronic assembly may further include a second dielectric layer on the material at the second surface of the glass layer, the second dielectric layer including a third conductive pathway electrically coupled to the first via and a fourth conductive pathway electrically coupled to the second via.

Example 13 may include the subject matter of Example 12, and may further include a circuit board at the second dielectric layer and electrically coupled to the third conductive pathway and the fourth conductive pathway.

Example 14 is a microelectronic assembly, including a glass layer having a first surface, an opposing second surface, and side surfaces extending between the first and second surfaces, the glass layer including a cavity; a material in the cavity and on the first, second, and side surfaces of the glass layer, wherein the material includes an organic dielectric, a mold material, an epoxy-based organic material, an epoxy material, or an epoxy material with silica fillers; a first via extending through the glass layer and through the material on the first and second surfaces of the glass layer, the first via including a conductive material; a second via extending through the material in the cavity, wherein the second via includes a plug material surrounded by a conductive material and the conductive material is surrounded by a magnetic material; and a dielectric layer on the material at the first surface of the glass layer, the dielectric layer including a first conductive pathway electrically coupled to the first via and a second conductive pathway electrically coupled to the second via.

Example 15 may include the subject matter of Example 14, and may further specify that a thickness of the material on the first surface or the second surface of the glass layer is between 5 microns and 100 microns.

Example 16A may include the subject matter of Example 14 or 15, and may further include a space between the glass layer and the conductive material of the first via, where the space is between 50 nanometers and 200 nanometers.

Example 16B may include the subject matter of Example 14 or 15, and may further specify that the conductive material of the first via is not physically attached to the glass layer.

Example 17 may include the subject matter of any one of Examples 14-16, and may further specify that the magnetic material includes a ferromagnetic material.

Example 18 may include the subject matter of any one of Examples 14-17, and may further specify that the plug material includes a plugging resin.

Example 19 may include the subject matter of any one of Examples 14-18, and may further include a liner material on the first surface, on the second surface, and in the cavity between the glass layer and the material, and in the first via between the glass layer and the conductive material of the first via, wherein the conductive material of the first via is not attached to the liner material.

Example 20 may include the subject matter of Example 19, and may further specify that the liner material includes one or more of parylene; silicon and nitrogen; silicon, oxygen, and nitrogen; silicon, oxygen, and carbon; silicon and oxygen; or a polyimide.

Example 21 may include the subject matter of any one of Examples 14-20, and may further include a reinforcing material on the material at the first surface and the second surface of the glass layer along at least one of the side surfaces of the glass layer.

Example 22 may include the subject matter of Example 21, and may further specify that the reinforcing material includes Glass Cloth Prepreg (GCP) material or a Resin Coated Copper (RCC) material.

Example 23 may include the subject matter of Example 21 or 22, and may further specify that the reinforcing material is along at least two of the side surfaces of the glass layer.

Example 24 may include the subject matter of any one of Examples 14-23, and may further include a die electrically coupled to the first conductive pathway or the second conductive pathway in the dielectric layer.

Example 25 may include the subject matter of any one of Examples 14-24, and may further specify that the dielectric layer is a first dielectric layer including the first conductive pathway and the second conductive pathway, and the microelectronic assembly may further include a second dielectric layer on the material at the second surface of the glass layer, the second dielectric layer including a third conductive pathway electrically coupled to the first via and a fourth conductive pathway electrically coupled to the second via.

Example 26 may include the subject matter of Example 25, and may further include a circuit board at the second dielectric layer and electrically coupled to the third conductive pathway and the fourth conductive pathway.

Example 27 is a microelectronic assembly, including a glass layer having a first surface, an opposing second surface, and side surfaces extending between the first and second surfaces, the glass layer including a cavity; a passive component in the cavity; a material around the passive component in the cavity and on the first, second, and side surfaces of the glass layer, the material including an organic dielectric material; a via extending through the glass layer and through the material on the first and second surfaces of the glass layer, the via including a conductive material; and a dielectric layer on the material at the first surface of the glass layer, the dielectric layer including conductive pathways electrically coupled to the conductive via and to the passive component.

Example 28 may include the subject matter of Example 27, and may further specify that a thickness of the material on the first surface or the second surface of the glass layer is between 5 microns and 100 microns.

Example 29A may include the subject matter of Example 27 or 28, and may further include a space between the glass layer and the conductive material of the via, where the space is between 50 nanometers and 200 nanometers.

Example 29B may include the subject matter of Example 27 or 28, and may further specify that the conductive material of the via is not physically attached to the glass layer.

Example 30 may include the subject matter of any one of Examples 27-29, and may further include a liner material on the first surface, on the second surface, in the cavity between the glass layer and the material, and in the via between the glass layer and the conductive material of the via, wherein the conductive material of the via is not attached to the liner material.

Example 31 may include the subject matter of Example 30, and may further specify that the liner material includes one or more of parylene; silicon and nitrogen; silicon, oxygen, and nitrogen; silicon, oxygen, and carbon; silicon and oxygen; or a polyimide.

Example 32 may include the subject matter of any one of Examples 27-31, and may further include a reinforcing material on the material at the first surface and the second surface of the glass layer along at least one of the side surfaces of the glass layer.

Example 33 may include the subject matter of Example 32, and may further specify that the reinforcing material includes Glass Cloth Prepreg (GCP) material or a Resin Coated Copper (RCC) material.

Example 34 may include the subject matter of any one of Examples 27-33, and may further specify that the passive component includes a discrete inductor or a discrete capacitor.

Example 35 may include the subject matter of Example 34, and may further specify that the passive component includes a discrete inductor.

## Claims

1. A microelectronic assembly, comprising:
a glass layer having a first surface, an opposing second surface, and side surfaces extending between the first and second surfaces, the glass layer including a cavity;
a material in the cavity and on the first surface, the second surface, and the side surfaces of the glass layer, wherein the material includes an organic dielectric, a mold material, an epoxy-based organic material, an epoxy material, or an epoxy material with silica fillers;
a first via extending through the glass layer and through the material on the first and second surfaces of the glass layer, the first via including a conductive material;
a second via extending through the material in the cavity, the second via including a conductive material surrounded by a magnetic material; and
a dielectric layer on the material at the first surface of the glass layer, the dielectric layer including a first conductive pathway electrically coupled to the first via and a second conductive pathway electrically coupled to the second via.

2. The microelectronic assembly of claim 1, wherein the second via further includes a plug material surrounded by the conductive material and the conductive material is surrounded by a magnetic material.

3. The microelectronic assembly of claim 1 or 2, wherein the magnetic material includes a ferromagnetic material.

4. The microelectronic assembly of claim 2, wherein the plug material includes a plugging resin.

5. A microelectronic assembly, comprising:
a glass layer having a first surface, an opposing second surface, and side surfaces extending between the first and second surfaces, the glass layer including a cavity;
a passive component in the cavity;
a material around the passive component in the cavity and on the first surface, the second surface, and the side surfaces of the glass layer, the material including an organic dielectric, a mold material, an epoxy-based organic material, an epoxy material, or an epoxy material with silica fillers;
a via extending through the glass layer and through the material on the first and second surfaces of the glass layer, the via including a conductive material; and
a dielectric layer on the material at the first surface of the glass layer, the dielectric layer including conductive pathways electrically coupled to the conductive via and to the passive component.

6. The microelectronic assembly of claim 5, wherein the passive component includes a discrete inductor or a discrete capacitor.

7. The microelectronic assembly of claim 6, wherein the passive component includes a discrete inductor.

8. The microelectronic assembly of any one of the preceding claims, wherein a thickness of the material on the first surface or the second surface of the glass layer is between 5 microns and 100 microns.

9. The microelectronic assembly of any one of the preceding claims, wherein a thickness of the material on the side surfaces of the glass layer is between 10 microns and 500 microns.

10. The microelectronic assembly of any one of the preceding claims, wherein the conductive material of the first via is not physically attached to the glass layer.

11. The microelectronic assembly of any one of the preceding claims, further comprising:
a space between the glass layer and the conductive material of the first via, where the space is between 50 nanometers and 200 nanometers.

12. The microelectronic assembly of any one of the preceding claims, further comprising:
a liner material on the first surface, on the second surface, and in the cavity between the glass layer and the material, and in the first via between the glass layer and the conductive material of the first via.

13. The microelectronic assembly of claim 12, wherein the liner material includes one or more of parylene; silicon and nitrogen; silicon, oxygen, and nitrogen; silicon, oxygen, and carbon; silicon and oxygen; or a polyimide.

14. The microelectronic assembly of any one of the preceding claims, further comprising:
a reinforcing material on the material at the first surface and the second surface of the glass layer along at least one of the side surfaces of the glass layer.

15. The microelectronic assembly of claim 14, wherein the reinforcing material includes Glass Cloth Prepreg (GCP) material or a Resin Coated Copper (RCC) material.
